# EUROPEAN PATENT SPECIFICATION

(11) **EP 3 157 317 B1**
(45) Date of publication and mention of the grant of the patent: **26.12.2018**
(21) Application number: 16158530.2
(22) Date of filing: 03.03.2016
(51) Int. Cl.: H05K 1/02, H05K 7/20, H05K 9/00

(54) **SHIELDING CASE, PCB AND TERMINAL DEVICE**
ABSCHIRMUNGSGEHÄUSE, LEITERPLATTE UND ENDGERÄTEVORRICHTUNG
BOÎTIER DE BLINDAGE, CARTE DE CIRCUITS IMPRIMÉS ET DISPOSITIF TERMINAL

(30) Priority: 14.10.2015 CN 201510660841
(43) Date of publication of application: 19.04.2017
(73) Proprietor: Xiaomi Inc., Beijing 100085 (CN)
(72) Inventor: WANG, Dongliang, 100085 Haidian District (CN); WANG, Shaojie, 100085 Haidian District (CN); SHI, Shasha, 100085 Haidian District (CN)
(74) Representative: Grunert, Marcus

(56) References cited:
- WO-A2-2016/053966
- DE-A1-102009 014 852
- US-A1- 2013 329 369
- US-A1- 2014 043 769
- US-A1- 2014 118 942
- US-B2- 7 623 360

## Description

### TECHNICAL FIELD

The present disclosure generally relates to the shield of electronic components, and more particularly, to a shielding case, a Printed Circuit Board (PCB) using the shielding case and a terminal device using the PCB.

### BACKGROUND

With the development of economy and society, people have a growing demand on the performance of terminal devices such as a mobile phone. Accordingly, the power consumption of the electronic components is increasing; therefore, heat dissipation becomes a problem all manufacturers must confront with.

WO 2016/053966 A2 discloses a multicomponent shield can for temporary heat storage and junction temperature regulation using a phase change material the shield can consisting of a wall and a lid, the lid consisting of a hollow cavity which can be filled with a material.

US 7 623 360 B2 discloses a shielding and thermal management assembly with a frame, a thermal interface and a heat spreader.

US 2014/043769 discloses a thermal buffering element, which includes a heat absorbing material and a plurality of metal particles.

### SUMMARY

Accordingly, the present invention provides a shielding case, a PCB and a terminal device.

According to a first aspect, the invention relates to a shielding case, which includes: a first shielding case body and a second shielding case body that are interconnected, wherein the first shielding case body has a first top wall and a first side wall, the second shielding case body has a second top wall and a second side wall, the second shielding case body is at least partially covered outside the first shielding case body, and a heat storage material is accommodated between the first shielding case body and the second shielding case body.

According to the invention, the second shielding case body is covered outside both the first top wall and the first side wall.
According to the invention, the second shielding case body is connected with the first shielding case body through multiple joint pins that are arranged along a circumference direction at intervals; an inner end of the joint pin is connected with a corner between the first top wall and the first side wall, while an outer end is connected with a corner between the second top wall and the second side wall; the heat storage material includes a first heat storage material located between the first top wall and the second top wall and a second heat storage material located between the first side wall and the second side wall.
According to an exemplary embodiment, multiple ventilation holes distributed at intervals may be formed on the second shielding case body.
According to a second aspect, the invention relates to a PCB, which includes: a board body and a heating component disposed on the board body, wherein a shielding case that is described in the above embodiment of the present disclosure is covered on the heating component, and the shielding case is connected onto the board body; or, a first shielding case body is covered on the heating component, a second shielding case body is covered outside the first shielding case body, the first shielding case body and the second shielding case body are connected onto the board body respectively, and a heat storage material is accommodated between the first shielding case body and the second shielding case body.
According to a third aspect, the invention relates to a terminal device, which includes a PCB described in the above embodiment of the present disclosure provided in the terminal device.
According to an exemplary embodiment, the terminal device may be a mobile phone or a tablet computer.
The technical scheme provided in the embodiment of the present disclosure has following advantages: the heat storage material accommodated between the two shielding case bodies can absorb and store the heat radiated by a heating component and then gradually dissipates the heat; therefore, the present disclosure not only realizes the dissipation of heat from a heating component that is running at a high speed, but also avoids the dissipated heat being directly radiated onto the outside of a terminal device to impact user experience; moreover, the double-layer structure has a big superficial surface for absorbing heat, which strengthens the effect of heat control.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is a section diagram of a PCB, according to a first alternative solution
Fig. 2 is a section diagram of a PCB, according to a first exemplary embodiment.
Fig. 3 is a section diagram of a PCB, according to a second exemplary embodiment.
Fig. 4 is a structure stereogram of a shielding case, according to the first exemplary embodiment.

### DETAILED DESCRIPTION

Reference will now be made in detail to exemplary embodiments, and alternative solutions, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

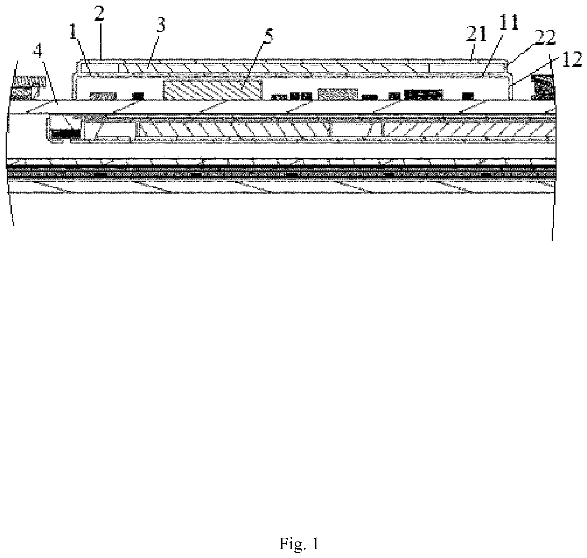

Position words employed hereinafter such as "upper, lower, left, right" generally are relative to the surface direction of a corresponding accompanying drawing if no particular description is specified, and specifically can refer to the surface direction as shown in Fig. 1 to Fig. 3; "inner and outer" refer to the inner side and outer side of the profile of a corresponding part.

As shown in Fig. 1 to Fig. 3, exemplary embodiments and alternative solutions for the present disclosure provide a shielding case, a PCB and a terminal device, wherein the terminal device may be a device a user often needs to handheld, such as a mobile phone, a tablet computer and the like. The significant heating source of the terminal device is a heating component 5 on the PCB, for example, a master chip. This type of heating component 5 will release a large amount of heat while running at a high speed. An exemplary embodiment of the present disclosure can effectively control the impact of the heat radiation of the heating component 5 onto user experience.

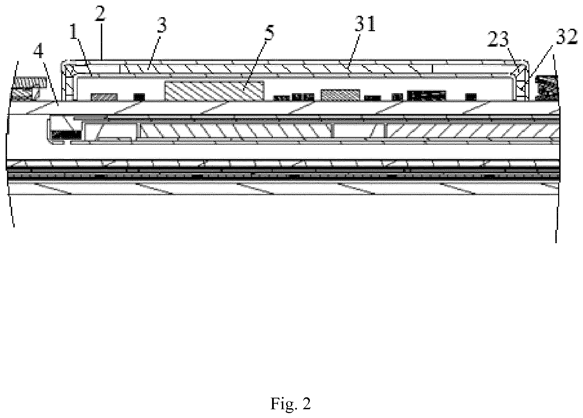

In order to improve the heat radiation of terminal devices, as shown in Fig. 1 and Fig. 2, an alternative solution and a first exemplary embodiment of the present disclosure provide a PCB. including: a board body 4 and a heating component 5 disposed on the board body 4, wherein a shielding case is covered on the heating component 5, and the shielding case is connected onto the board body 4, for example, welded onto the board body 4. The shielding case itself can shield the radiation from an element that is running at a high speed (such as the heating component 5), to prevent the interference onto other elements; the shielding case can be made of stainless steel or copper-nickel alloy and other shielding materials.

In order to control the heat radiation of the heating component 5, the shielding case provided in exemplary embodiments of the present disclosure includes: a first shielding case body 1 and a second shielding case body 2 that are interconnected, wherein the first shielding case body 1 has a first top wall 11 and a first side wall 12, the second shielding case body 2 has a second top wall 21 and a second side wall 22, the side walls of the two shielding case bodies can extend downwards from the top wall perpendicularly or extend slantwise slightly, to form a shield shaped structure. The second shielding case body 2 at least partially covers the first shielding case body 1, and a heat storage material 3 is accommodated between the first shielding case body 1 and the second shielding case body 2.

In this way, the heat storage material 3 accommodated between the two shielding case bodies can absorb and store the heat radiated by a heating component 5 and then gradually dissipates the heat; therefore, the present disclosure not only realizes the dissipation of heat from the heating component 5 that is running at a high speed, but also avoids the dissipated heat being directly radiated onto the outside of a terminal device to impact user experience; moreover, the double-layer structure has a big superficial surface for absorbing heat, which strengthens the effect of heat control. In other possible embodiments, the shielding case body can be designed to be more layers, which depend on the volume of the terminal device and the heating control effect. In addition, in the exemplary embodiments of the present disclosure, the heat storage material 3 can adopt a material with a lower heat conductivity coefficient, for example, silica gel with a lower heat conductivity coefficient.

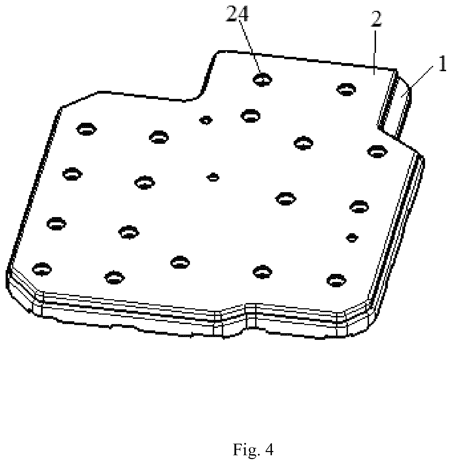

As shown in Fig. 1 and Fig. 4, in the alternative solution to the present disclosure, the second shielding case body 2 at least partially covers the first top wall 11; thus, the top wall 11 in the first shielding case body 1 having a relatively big area bears the heat storage material 3; further, it is simple to mount the first shielding case body onto the board body 4 of the PCB, specifically, it is only needed to weld the bottom of the first side wall 12 onto the board body 4. The two shielding case bodies can be stamped respectively and then are welded mutually; to better connect the two shielding case bodies, the cross section area of the second shielding case body 2 is less than that of the first shielding case body 1; the bottom of the second side wall 22 of the smaller second shielding case body 2 can be conveniently welded onto the first top wall 11 of the first shielding case body 1. In other possible solutions the cross section areas of the two shielding case bodies might be the same; the two shielding case bodies, or, the two shielding case bodies and the board body 4 can be connected by a demountable method such as clamping and plug-in.

As shown in Fig. 2, in the first exemplary embodiment of the present disclosure, which is different from the alternative solution shown in Fig. 1, the second shielding case body 2 covers both the first top wall 11 and the first side wall 12. In this way, when the heating component 5 is operating, the heat radiated from the heating component 5 can be absorbed and stored by both the top and side walls, thus the heat of the terminal device can be controlled.

To connect the two shielding case bodies, in the first exemplary embodiment, the second shielding case body 2 is connected with the first shielding case body 1 through multiple joint pins 23 that are arranged along the circumference direction at intervals; an inner end of the joint pin 23 is connected with a corner between the first top wall and the first side wall, while an outer end is connected with a corner between the second top wall and the second side wall; in this way, the heat storage material 3 may include a first heat storage material 31 located between the first top wall and the second top wall, for example, a plate shaped heat storage material, and a second heat storage material 32 located between the first side wall and the second side wall, for example, a ring shaped heat storage material. Since there are gaps among the multiple joint pins 23, the space between the two shielding case bodies is interconnected, so that the two heat storage materials 3 can mutually cooperate to better absorb and store heat from the top and side walls of the heating component 5.

The first heat storage material 31 and the second heat storage material 32 can be integrated, that is so say, through holes for the joint pins 23 to pass through are formed on the integrated structure, or, the first heat storage material and the second heat storage material are independent, that is to say, they are assembled between the top walls, between the side walls of the two shielding case bodies respectively. In some possible embodiments, the two shielding case bodies can also be connected through joint pins located at the corners, wherein the joint pin can also be disposed on the top wall or the side wall.

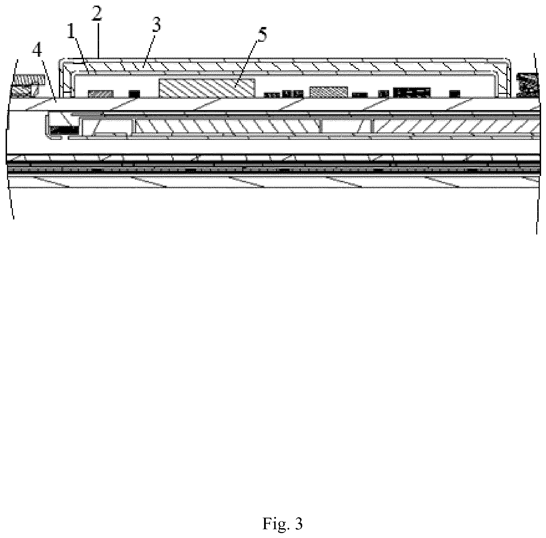

In the first exemplary embodiment, both the shielding case bodies are of a whole structure; however, as shown in Fig. 3, in a second exemplary embodiment of the present disclosure, the two shielding case bodies may be not directly connected; in this way, the first shielding case body 1 covers the heating component 5, the second shielding case body 2 covers the first shielding case body 1, the first shielding case body 1 and the second shielding case body 2 are interconnected by being connected onto the board body 4 respectively, for example, by welding, moreover a heat storage material 3 is accommodated between the first shielding case body 1 and the second shielding case body 2. The second embodiment can also accomplish the heat control on the heating component 5 through the heat storage material disposed between the two shielding case bodies. In the second exemplary embodiment the two shielding case bodies can be the same as or similar to the two shielding case bodies in the first embodiment in structure; the heat storage material 3 between the two shielding case bodies can be disposed between the top walls and between the side walls at the same time, or, between top walls only in other possible embodiments.

In addition, as shown in Fig. 4, in an exemplary embodiment of the present disclosure multiple ventilation holes 24 distributed at intervals are formed on the second shielding case body 2. Through the ventilation holes, the heat storage material can dissipate heat after absorbing and storing the heat, thereby reducing the heat absorption load of the heat storage material. Likewise, similar ventilation holes 24 can be formed on the second shielding case body 2 in other embodiments. In addition, the shape of the shielding case body can be determined according to the number and layout of the electronic elements to be covered.

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with the scope of the invention being indicated by the following claims.

It will be appreciated that the present invention is not limited to the exact construction that has been described above and illustrated in the accompanying drawings, and that various modifications and changes can be made without departing from the scope thereof. It is intended that the scope of the invention only be limited by the appended claims.

### INDUSTRIAL APPLICABILITY

A heat storage material accommodated between two shielding case bodies can absorb and store heat radiated by a heating component and then gradually dissipates the heat; therefore, the present disclosure not only realizes the dissipation of heat from the heating component that is running at a high speed, but also avoids the dissipated heat being directly radiated onto the outside of a terminal device to impact user experience; moreover, the double-layer structure has a big superficial surface for absorbing the heat, which strengthens the effect of heat control.

## Claims

1. A shielding case, wherein the shielding case comprises: a first shielding case body (1) and a second shielding case body (2) that are interconnected, wherein the first shielding case body (1) has a first top wall (11) and a first side wall (12), the second shielding case body (2) has a second top wall (21) and a second side wall (22), wherein the second shielding case body (2) at least partially covers the first shielding case body (1), and a heat storage material (3) is accommodated between the first shielding case body (1) and the second shielding case body (2) ;
wherein the second shielding case body (2) covers both the first top wall (11) and the first side wall (12);
**characterised in that** the second shielding case body (2) is connected with the first shielding case body (1) through multiple joint pins (23) that are arranged along a circumference direction at intervals; an inner end of the joint pin (23) is connected with a corner between the first top wall (11) and the first side wall (12), while an outer end is connected with a corner between the second top wall (21) and the second side wall (22); the heat storage material (3) comprises a first heat storage material (31) located between the first top wall (11) and the second top wall (21) and a second heat storage material (32) located between the first side wall (12) and the second side wall (22) .

2. The shielding case according to claim 1, wherein multiple ventilation holes (24) distributed at intervals are formed on the second shielding case body (2).

3. Assembly of a Printed Circuit Board (PCB) and a shielding case according to any one of claims 1 to 2, **characterised in that** the PCB comprises: a board body (4) and a heating component (5) disposed on the board body (4), wherein the shielding case covers the heating component (5), and the shielding case is connected onto the board body (4).

4. An assembly according to claim 3, wherein the first shielding case body covers the heating component (5), the second shielding case body (2) at least partially covers the first shielding case body (1), the first shielding case body (1) and the second shielding case body (2) are connected onto the board body (4) respectively, and a heat storage material (3) is accommodated between the first shielding case body (1) and the second shielding case body (2).

5. A terminal device, **characterised in that** the terminal device comprises: an assembly according to any one of claims 3 and 4 provided in the terminal device,

6. The terminal device according to claim 5, wherein the terminal device is a mobile phone or a tablet computer.

## Patentansprüche

1. Abschirmgehäuse, wobei das Abschirmgehäuse folgendes aufweist: einen ersten Abschirmgehäusekörper (1) und einen zweiten Abschirmgehäusekörper (2), die miteinander verbunden sind, wobei der erste Abschirmgehäusekörper (1) eine erste obere Wand (11) und eine erste Seitenwand (12) aufweist, wobei der zweite Abschirmgehäusekörper (2) eine zweite obere Wand (21) und eine zweite Seitenwand (22) aufweist, wobei der zweite Abschirmgehäusekörper (2) zumindest teilweise den ersten Abschirmgehäusekörper (1) bedeckt und ein Wärmespeichermaterial (3) zwischen dem ersten Abschirmgehäusekörper (1) und dem zweiten Abschirmgehäusekörper (2) untergebracht ist;
wobei der zweite Abschirmgehäusekörper (2) sowohl die erste obere Wand(11) als auch die erste Seitenwand (12) abdeckt;
**dadurch gekennzeichnet, dass** der zweite Abschirmgehäusekörper (2) mit dem ersten Abschirmgehäusekörper (1) durch mehrere Verbindungsstifte (23) verbunden ist, die entlang einer Umfangsrichtung in Intervallen angeordnet sind; wobei ein inneres Ende des verbundenen Stiftes (23) mit einer Ecke zwischen der ersten oberen Wand (11) und der ersten Seitenwand (12) verbunden ist, während ein äußeres Ende mit einer Ecke zwischen der zweiten oberen Wand (21) und der zweiten Seitenwand (22) verbunden ist; wobei das Wärmespeichermaterial (3) ein erstes Wärmespeichermaterial (31), das zwischen der ersten oberen Wand (11) und der zweiten oberen Wand (21) angeordnet ist, und ein zweites Wärmespeichermaterial (32), das zwischen der ersten Seitenwand (12) und der zweiten Seitenwand (22) angeordnet ist, aufweist.

2. Abschirmgehäuse nach Anspruch 1, wobei mehrere Belüftungslöcher (24), die in Intervallen verteilt sind, auf dem zweiten Abschirmgehäusekörper (2) ausgebildet sind.

3. Anordnung einer Leiterplatte (PCB) und eines Abschirmgehäuses nach einem der Ansprüche 1 bis 2, **dadurch gekennzeichnet, dass** die PCB folgendes aufweist: einen Plattenkörper (4) und eine Heizkomponente (5), die auf dem Plattenkörper (4) angeordnet ist, wobei das Abschirmgehäuse die Heizkomponente (5) abdeckt und das Abschirmgehäuse auf dem Plattenkörper (4) verbunden ist.

4. Anordnung nach Anspruch 3, wobei der erste Abschirmgehäusekörper die Heizkomponente (5) abdeckt, der zweite Abschirmgehäusekörper (2) zumindest teilweise den ersten Abschirmgehäusekörper (1) abdeckt, wobei der erste Abschirmgehäusekörper (1) und der zweite Abschirmgehäusekörper (2) jeweils auf dem Plattenkörper (4) verbunden sind und ein Wärmespeichermaterial (3) zwischen dem ersten Abschirmgehäusekörper (1) und dem zweiten Abschirmgehäuse (2) untergebracht ist.

5. Anschlussvorrichtung, wobei die Anschlussvorrichutng folgendes aufweist:
eine Anordnung nach einem der Ansprüche 3 und 4, die in der Anschlussvorrichtung bereitgestellt ist.

6. Anschlussvorrichtung nach Anspruch 5, wobei die Anschlussvorrichtung ein Mobiltelephon oder ein Tablet-Computer ist.

## Revendications

1. Boîtier de protection, dans lequel le boîtier de protection comporte : un premier corps de boîtier de protection (1) et un second corps de boîtier de protection (2) qui sont mutuellement reliés, dans lequel le premier corps de boîtier de protection (1) a une première paroi supérieure (11) et une première paroi latérale (12), le second corps de boîtier de protection (2) a une seconde paroi supérieure (21) et une seconde paroi latérale (22), dans lequel le second corps de boîtier de protection (2) recouvre au moins partiellement le premier corps de boîtier de protection (1), et un matériau d'accumulation de chaleur (3) est reçu entre le premier corps de boîtier de protection (1) et le second corps de boîtier de protection (2) ;
dans lequel le second corps de boîtier de protection (2) recouvre à la fois la première paroi supérieure (11) et la première paroi latérale (12) ;
**caractérisé en ce que** le second corps de boîtier de protection (2) est relié au premier corps de boîtier de protection (1) par de multiples plots de jonction (23) qui sont agencés le long d'une direction circonférentielle à des intervalles ;
une extrémité intérieure du plot de jonction (23) est reliée à un coin entre la première paroi supérieure (11) et la première paroi latérale (12), alors qu'une extrémité extérieure est reliée à un coin entre la seconde paroi supérieure (21) et la seconde paroi latérale (22) ; le matériau d'accumulation de chaleur (3) comporte un premier matériau d'accumulation de chaleur (31) situé entre la première paroi supérieure (11) et la seconde paroi supérieure (21) et un second matériau d'accumulation de chaleur (32) situé entre la première paroi latérale (12) et la seconde paroi latérale (22).

2. Boîtier de protection selon la revendication 1, dans lequel de multiples trous de ventilation (24) répartis à des intervalles sont formés sur le second corps de boîtier de protection (2).

3. Assemblage d'une carte à circuit imprimé (PCB) et d'un boîtier de protection selon l'une quelconque des revendications 1 à 2, **caractérisé en ce que** la PCB comporte : un corps de carte (4) et un composant chauffant (5) disposé sur le corps de carte (4), dans lequel le boîtier de protection recouvre le composant chauffant (5), et le boîtier de protection est connecté sur le corps de carte (4).

4. Assemblage selon la revendication 3, dans lequel le premier corps de boîtier de protection recouvre le composant chauffant (5), le second corps de boîtier de protection (2) recouvre au moins partiellement le premier corps de boîtier de protection (1), le premier corps de boîtier de protection (1) et le second corps de boîtier de protection (2) sont respectivement connectés sur le corps de carte (4), et un matériau d'accumulation de chaleur (3) est reçu entre le premier corps de boîtier de protection (1) et le second corps de boîtier de protection (2).

5. Dispositif terminal, **caractérisé en ce que** le dispositif terminal comporte : un assemblage selon l'une quelconque des revendications 3 et 4 fourni dans le dispositif terminal.

6. Dispositif terminal selon la revendication 5, dans lequel le dispositif terminal est un téléphone mobile ou une tablette électronique.
